Europäisches Patentamt

European Patent Office

Office européen des brevets

(11) Numéro de publication: **0 194 924**
**A1**

## DEMANDE DE BREVET EUROPEEN

(21) Numéro de dépôt: **86400451.0**

(22) Date de dépôt: **04.03.86**

(51) Int. Cl.⁴: **H03K 5/153** , G01S 13/78 ,
G01S 13/14

(30) Priorité: **05.03.85 FR 8503228**

(43) Date de publication de la demande:
**17.09.86 Bulletin  86/38**

(84) Etats contractants désignés:
**DE GB IT**

(71) Demandeur: **THOMSON-CSF**
**173, Boulevard Haussmann**
**F-75379 Paris Cedex 08(FR)**

(72) Inventeur: **Hetyei, Joseph**
**THOMSON-CSF SCPI 19, avenue de Messine**
**F-75008 Paris(FR)**

(74) Mandataire: **Benoit, Monique et al**
**THOMSON-CSF SCPI 19, avenue de Messine**
**F-75008 Paris(FR)**

(54) **Dispositif de détection d'un train d'impulsions dans du bruit, et application à un système de radionavigation du type DME.**

(57) L'invention a pour objet un dispositif de détection, au milieu de bruit, de chacune des impulsions d'un train d'impulsions.

Il comporte principalement : un détecteur (D) de la crête $(V_c)$ d'une impulsion ; une première ligne à retard $(R_0)$ conférant un retard $(\tau_0)$ au signal reçu ; un premier comparateur $(C_0)$ comparant le niveau de la première impulsion reçue à la demi-valeur crête $(V_c/2)$ ; une seconde ligne à retard $(R_1)$ assurant parallèlement un deuxième retard $(\tau_1)$ au signal d'entrée, différent du premier; un second comparateur $(C_1)$ comparant le signal (C) délivré par une deuxième ligne à retard $(R_1)$ au signal (B) délivré par la première ligne à retard $(R_0)$ et à la demi-valeur crête $(V_c/2)$, et une porte ET (L) fournissant un signal de sortie (S) quand il y a coïncidence des signaux de sortie des deux comparateurs.

FIG_3

Rank Xerox

# DISPOSITIF DE DETECTION D'UN TRAIN D'IMPULSIONS DANS DU BRUIT ET APPLICATION A UN SYSTEME DE RADIONAVIGATION DU TYPE DME

La présente invention a pour objet un dispositif assurant la détection, au milieu de bruit, de chacune des impulsions d'un train d'impulsions.

Dans certaines applications, comme les systèmes d'aide à la navigation aérienne du type DME (initiale de l'expression anglosaxonne Distance Measuring Equipement, c'est-à-dire équipement de mesure de distance), il est nécessaire de détecter des trains d'impulsions, le train pouvant ne comporter que deux impulsions comme dans le cas du DME, et plus précisément d'identifier les impulsions afin d'en détecter l'espacement, qui est porteur d'information.

Différents dispositifs sont connus à cet effet, notamment dans le cadre des systèmes DME où cette détection est particulièrement critique. On rappelle en effet que, dans un système DME, les impulsions sont émises par paires et qu'on cherche à déterminer, à la réception, leur espacement qui est porteur d'information, l'instant d'arrivée de chacune des impulsions étant déterminé sur son front de montée, à mi-hauteur.

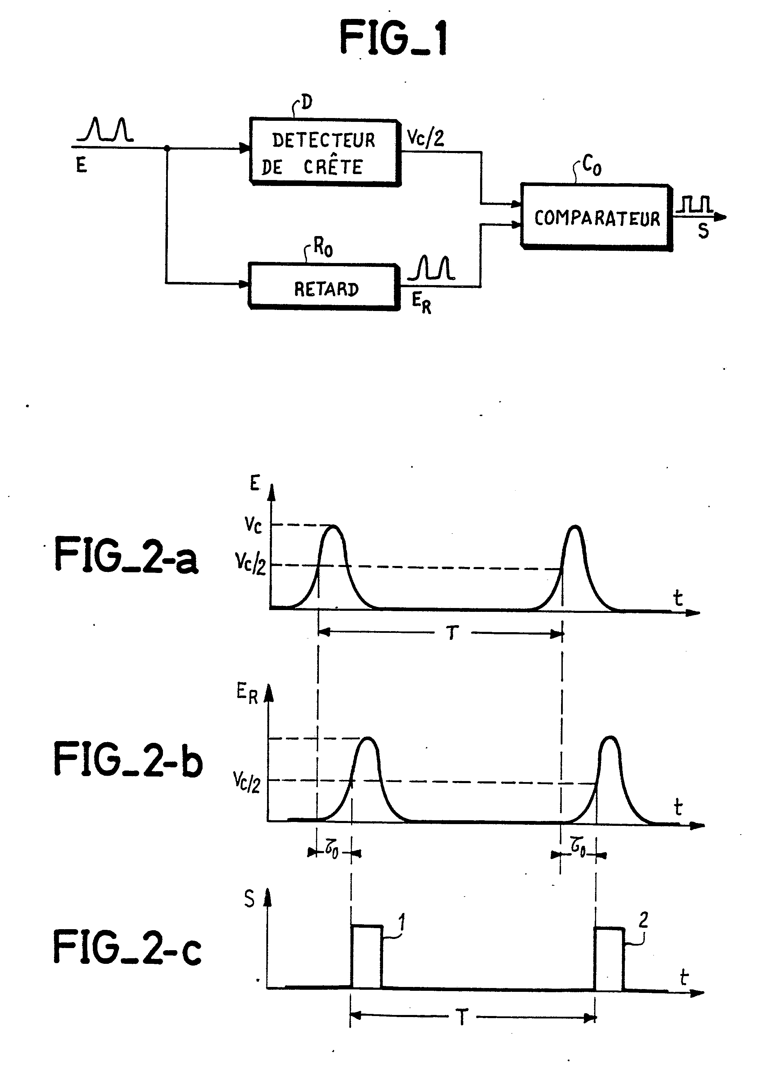

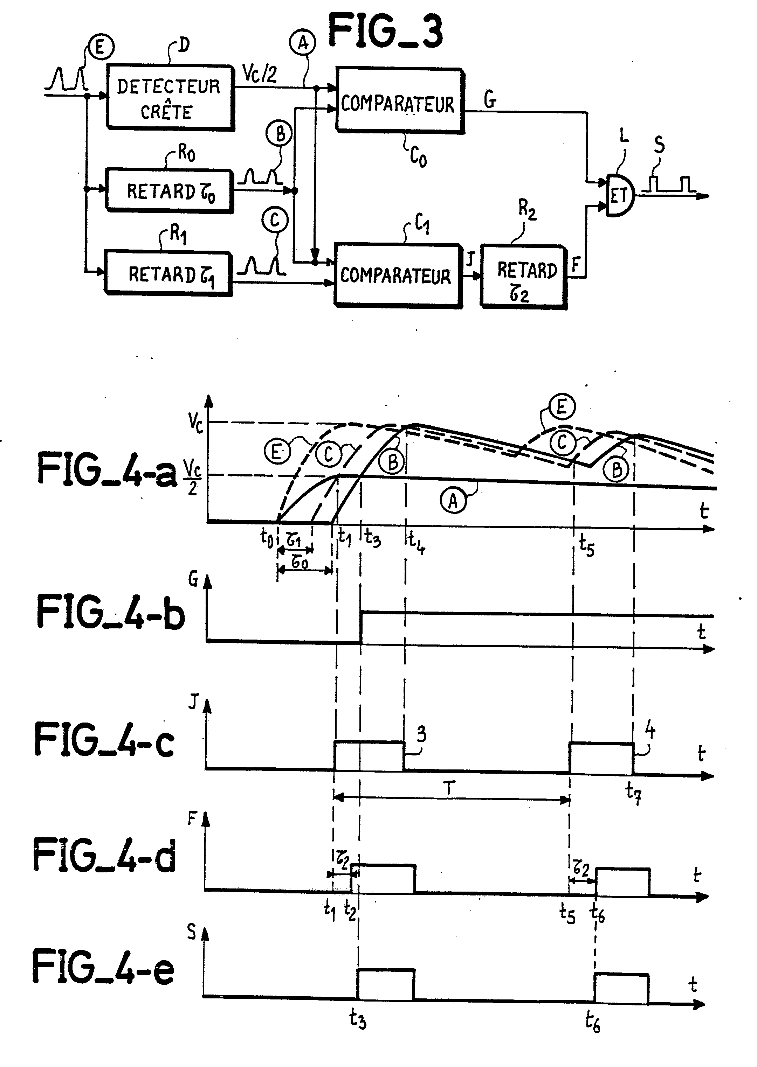

Un dispositif connu pour réaliser cette détection est représenté figure 1. Sur cette figure, une paire d'impulsions E, constituant le signal d'entrée, est appliquée d'une part à un détecteur de crête D, qui permet de définir la demi-hauteur de l'impulsion, c'est-à-dire $V_c/2$ où $V_c$ est la valeur de crête, et d'autre part à une ligne à retard $R_0$ ; les signaux issus des éléments D et $R_0$, notés respectivement $V_c/2$ et $E_R$, sont appliqués à un comparateur $C_0$ ; la ligne à retard $R_0$ a pour fonction de retarder d'une durée $\tau_0$ les impulsions d'entrée E de telle sorte qu'elles arrivent au comparateur $C_0$ en même temps que (ou après) la valeur $V_c/2$ détectée.

Le signal d'entrée E est représenté figure 2a, en fonction du temps : les deux impulsions ont sensiblement la même valeur crête $V_c$ et leur espacement T est compté comme l'intervalle de temps séparant le front de montée de chacune des impulsions, à mi-hauteur ($V_c/2$). La figure 2b représente, toujours en fonction du temps, le signal $E_R$ qui est identique au signal E mais retardé par rapport à celui-ci d'une durée $\tau_0$. Quand la première impulsion retardée ($E_R$) arrive au comparateur C, celui-ci compare son front de montée à $V_c/2$ et fournit un signal (une impulsion rectangulaire) à l'instant où ce front atteint la valeur $V_c/2$ ; le signal fourni par le comparateur C, noté S, est représenté en fonction du temps sur la figure 2c et la partie du signal S correspondant à la première impulsion du signal $E_R$ est repérée 1. Quand la deuxième impulsion formant le signal retardé $E_R$ atteint à son tour le comparateur C, celui-ci opère de même et fournit une deuxième impulsion rectangulaire notée 2 sur la figure 2c. Entre les fronts de montée des impulsions 1 et 2 du signal de sortie S, on retrouve bien l'espacement T qui séparerait les deux impulsions d'entrée E.

Il apparaît que le fonctionnement d'un tel dispositif nécessite que l'amplitude du signal d'entrée E entre deux impulsions descende au dessous de la valeur $V_c/2$ ; en effet, dans le cas contraire, le comparateur C est dans l'impossibilité d'identifier la deuxième impulsion. Toutefois, cette condition sur l'amplitude du signal E peut parfois ne pas être remplie en pratique, lorsque du bruit se superpose au train d'impulsions. Par exemple, lorsqu'un système DME fonctionne dans un environnement présentant des obstacles réfléchissant les ondes radioélectriques, ces obstacles renvoient avec un certain retard des impulsions DME qui se superposent alors aux signaux de propagation directe et forment un signal d'entrée composite, dont l'amplitude peut être supérieure à $V_c/2$ entre les deux impulsions. De ce fait, le rendement et la précision de l'ensemble du système DME diminue : le nombre des mesures valides se trouve réduit, jusqu'à devenir nul dans certain cas.

La présente invention a pour objet un dispositif de détection qui permet d'éviter cet inconvénient du fait qu'il ne nécessite pas la diminution de l'amplitude, entre deux impulsions, en dessous de la valeur $V_c/2$ . Selon l'invention, la première impulsion est détectée comme précédemment mais la seconde impulsion (ainsi que les éventuelles impulsions suivantes du train) est détectée par autocroisement, c'est-à-dire qu'on détecte le croisement du signal avec lui-même, convenablement retardé.

L'invention a plus précisément pour objet un dispositif de détection tel que défini par la revendication 1.

D'autres objet, particularités et résultats de l'invention ressortiront de la description suivante, donnée à titre d'exemple non limitatif et illustrée par les dessins annexés, qui représentent:

- la figure 1, déjà décrite, un dispositif de détection selon l'art antérieur ;

- les figures 2, a, b et c, déjà décrites, des diagrammes relatifs à la figure précédente ;

- la figure 3, le schéma d'un mode de réalisation du dispositif de détection selon l'invention ;

- la figure 4, a à e, des diagrammes relatifs à la figure précédente ;

- la figure 5, un exemple de réalisation pratique du dispositif selon l'invention.

Sur ces différentes figures, les mêmes références se rapportent aux mêmes éléments.

La figure 3 est donc un schéma synoptique d'un mode de réalisation du dispositif selon l'invention. Il sera décrit en liaison avec les diagrammes a à e de la figure 4, qui représentent la variation dans le temps de signaux pris en différents points du dispositif de la figure 3.

Le dispositif de détection reçoit donc un signal d'entrée E, qui est appliqué en parallèle à un détecteur de crête D, à un premier circuit de retard analogique $R_0$ et à un second circuit de retard analogique $R_1$.

Afin de simplifier l'exposé, le signal E est supposé formé de deux impulsions seulement, dont l'espacement T est prédéfini. Toutefois, pour mieux illustrer le fonctionnement du dispositif selon l'invention, le signal E, représenté en trait pointillé sur le diagramme a de la figure 4, est supposé très perturbé et, ce, suffisamment pour que sa valeur entre les deux impulsions soit supérieure à sa demi-valeur de crête $V_c/2$.

Sont également représentés sur le diagramme 4a :

- le signal A issu du détecteur de crête D et qui est un signal constant égal à $V_c/2$ après un certain temps de montée.

- le signal B issu du circuit de retard $R_0$, qui est donc de même forme que le signal d'entrée E mais retardé d'une durée $\tau_0$; il est représenté en trait continu ;

- le signal C issu du circuit de retard $R_1$, qui est identique également au signal E mais retardé d'une durée $\tau_1$, différente de $\tau_0$, avec $\tau_1 < \tau_0$ dans le cas particulier d'une application à un système DME.

Les signaux A et B sont, comme dans le dispositif connu décrit figure 1, appliqués à un premier comparateur $C_0$, dont le signal de sortie G est représenté sur le diagramme _b_ de la figure 4 : ce comparateur $C_0$ permet de détecter l'instant où le signal retardé B devient égal à $V_c/2$ (signal A) ; cet instant est noté $t_3$. Le signal G est donc à un niveau constant à partir de l'instant $t_3$, jusqu'à ce que le signal B redevienne inférieur à $V_c/2$, ce qui n'est pas illustré sur la figure 4.

Selon l'invention, le dispositif comporte un second comparateur, noté $C_1$, qui reçoit le signal C (signal d'entrée retardé de $\tau_1$) à comparer à la fois avec le signal B et avec le signal A ($V_c/2$). Le signal issu du comparateur $C_1$ est noté J et il est représenté sur le diagramme _c_ de la figure 4. Il apparaît qu'il s'établit à un niveau haut à un instant $t_1$ où le signal retardé C devient égal à $V_c/2$ et, ce, jusqu'à ce que le signal C voit son amplitude décroître, ce qui lui permet de croiser le signal B qui est, on le rappelle, le même signal mais retardé de $\tau_0$. Ce croisement est réalisé à un instant noté $t_4$. Si le signal retardé C ne redevient pas inférieur à $V_c/2$, c'est-à-dire s'il ne recroise pas le signal A, le signal J remonte au niveau haut à l'instant où l'amplitude du signal retardé C augmente à nouveau, instant noté $t_5$ où les signaux B et C retardés se croisent, et ce jusqu'à un instant noté $t_7$ où, l'amplitude du signal retardé C décroissant à nouveau, il croise encore une fois le signal B. Si l'amplitude du signal C redescend au dessous de la valeur $V_c/2$ (signal A), ce sont les croisements avec le signal A qui déclenchent les fronts de descente puis de montée du signal J.

De la sorte, en sortie du comparateur $C_1$, on obtient un signal J présentant deux créneaux, notés respectivement 3 et 4, dont l'espacement pris sur le front de montée correspond sensiblement à l'espacement T recherché. En effet, le front de montée du premier créneau (3) est obtenu par détection de la demi-valeur crête du signal (signal retardé C), puis les fronts de descente et de montée successifs sont obtenues par auto-croisement du signal par lui-même - (en pratique, des signaux retardés B et C). De la sorte, seul un changement de signe de la pente du signal E - (montée/descente) est nécessaire pour produire les fronts du signal J à $t_4$, $t_5$ et $t_7$, sans aucune condition sur l'amplitude du signal E après sa valeur crête.

Toutefois, dans un système DME notamment, l'instant de croisement du signal retardé B avec la demi-valeur de crête $V_c/2$ est une référence de temps utilisée par ailleurs ; le système comporte alors, en sortie, des moyens logiques L à coïncidence, du type porte ET par exemple, ayant pour effet d'aligner le front de montée du créneau 3 (signal J) avec l'instant $t_3$ comme représenté sur le diagramme _e_ de la figure 4, qui représente le signal de sortie S du dispositif.

Toutefois, afin de réaliser l'autocroisement décrit ci-dessus, on a conféré au signal C un retard $\tau_1$ inférieur à $\tau_0$, ce qui a pour effet que l'instant de départ ($t_1$) de la durée T est en avance sur l'instant $t_3$. Dans la variante de réalisation représentée sur les figures 3 et 4, afin de compenser ce décalage, un circuit de retard $R_2$ est rajouté à la sortie du comparateur $C_1$, le signal J étant alors retardé d'une durée $\tau_2$ pour devenir le signal F représenté sur le diagramme _d_ de la figure 4, avec $\tau_2 < \tau_0 - \tau_1$, mais voisin de cette valeur. Ainsi, le signal F est identique au signal J à ceci près que ses fronts de montée sont retardés de $\tau_2$ et interviennent respectivement aux instants $t_2$ et $t_6$. Le retard $\tau_2$ est choisi de façon à compenser autant que possible l'avance de l'instant $t_1$ sur l'instant $t_3$. On obtient ainsi pour le signal de sortie S deux impulsions rectangulaires (créneaux) dont les fronts de montée interviennent respectivement aux instants $t_3$, donné par le signal G (référence de temps du système DME), et $t_6$, donné par le signal F, avec $t_6 - t_3 \approx T$, T étant l'espacement recherché entre les impulsions ; entre ces instants, le signal S suit l'évolution du signal F, lui-même obtenu à partir du signal J retardé.

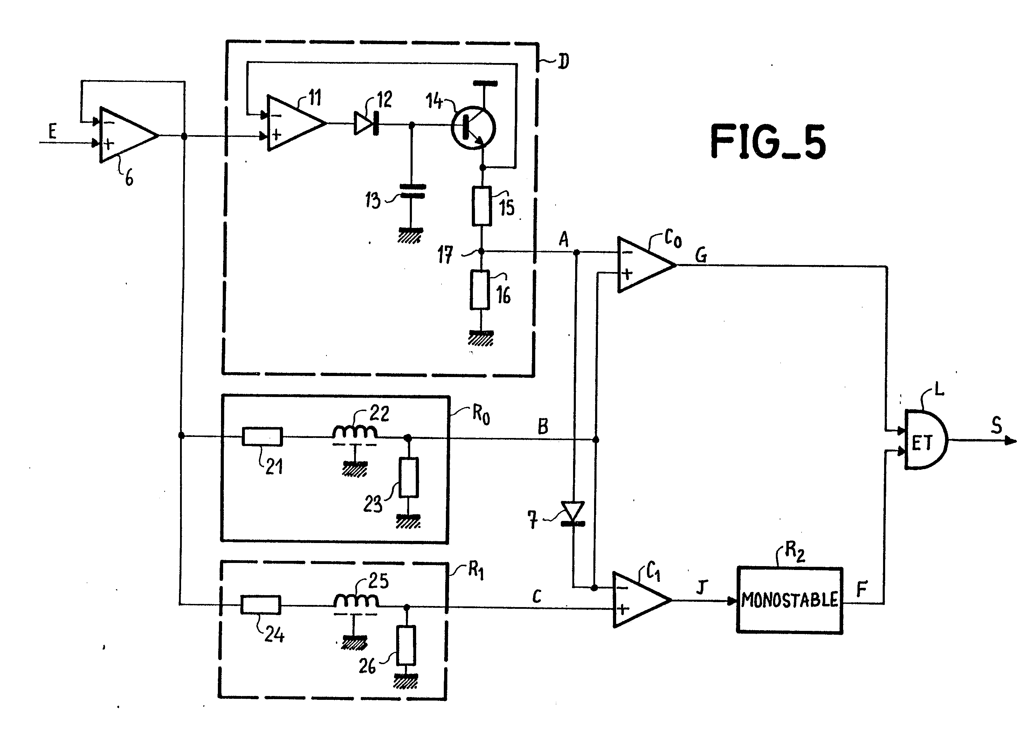

La figure 5 représente un exemple de réalisation pratique du dispositif de détection selon l'invention.

Sur cette figure, le signal E est appliqué à un amplificateur opérationnel 6, rebouclé sur lui-même, dont la fonction est de découpler le fonctionnement du dispositif selon l'invention de la chaîne de circuits qui précède.

Le signal E est donc appliqué en sortie de l'amplificateur 6, en parallèle, au détecteur de crête D et aux circuits retard $R_0$ et $R_1$ dont la constitution est détaillée ci-après. Les signaux de sortie, respectivement A, B, C, de ces trois blocs D, $R_0$ et $R_1$ sont appliqués aux comparateurs $C_0$ et $C_1$, formés chacun d'un amplificateur différentiel. Une connexion est réalisée entre la sortie du détecteur D et l'entrée (-) du comparateur $C_1$, afin d'assurer le déclenchement du comparateur $C_1$ sur $V_c/2$ (signal A, l'instant $t_1$); une diode 7 est placée sur cette connexion, anode côté détecteur et cathode côté comparateur, afin d'éviter que le signal B ne vienne perturber la valeur $V_c/2$ (A). Le signal J de sortie de comparateur $C_1$ est retardé d'une durée $\tau_2$ par le circuit $R_2$, qui peut être réalisé par un monostable : en effet, un monostable est un circuit logique avec lequel un retard peut être réglé plus précisément qu'avec une ligne à retard analogique. Il est à noter que la durée des créneaux formant le signal F dépend du monostable utilisé ; elle est indifférente dans le cas présent, sous réserve d'être suffisante pour englober l'instant $t_3$, c'est-à-dire au moins un peu supérieure à $(t_3 - \tau_1) - \tau_2$. Les signaux de sortie G et F des circuits $C_0$ et $R_2$ sont appliqués à la porte ET L pour fournir le signal de sortie S.

L'ensemble détecteur de crête D est constitué par un amplificateur différentiel 11, recevant le signal E sur sa sortie positive et dont la sortie est connectée à l'anode d'une diode 12, la cathode de celle-ci étant connectée à la base d'un transistor 14, par exemple de type NPN, dont le collecteur est réuni à une alimentation et l'émetteur est relié à la masse par l'intermédiaire de deux résistances 15 et 16 . L'émetteur du transistor 14 est également relié à l'entrée négative de l'amplificateur 11 et la base de ce même transistor 14 à la masse par l'intermédiaire d'une capacité 13. Il apparaît ainsi que le signal obtenu sur l'émetteur du transistor 14 augmente avec le signal d'entrée E jusqu'à la valeur crête $V_c$ et qu'à ce moment, du fait du rebouclage de l'émetteur du transistor 14 sur l'entrée négative de l'amplificateur 11, de la diode 12 et de la capacité 13, le niveau du signal sur l'émetteur ne redescend pas lorsque le signal d'entrée diminue : on a ainsi en permanence la valeur $V_c$ sur l'émetteur du transistor 14. Les résistances 15 et 16 sont utilisées pour diviser la tension crête par 4, la tension $V_c/4$ étant obtenue au point milieu, repéré 17, de ces résistances. On cherche à obtenir au point 17 une tension égale à $V_c/4$ et non à $V_c/2$ comme illustré sur la figure 3 pour tenir compte du fait que, en sortie des circuits retard $R_0$ et $R_1$, ce n'est pas le signal d'entrée qui est obtenu mais un signal dont l'amplitude est divisée par deux.

En effet, le circuit de retard $R_0$ comporte dans ce mode de réalisation une ligne à retard analogique, repérée 22, du type LC par exemple à constantes réparties, dont l'entrée reçoit le signal d'entrée par l'intermédiaire d'une résistance 21 dont la valeur est égale à l'impédance caractéristique de la ligne 22 ; de même, la sortie de la ligne 22 est reliée à la masse par l'intermédiaire d'une résistance 23 également égale à l'impédance caractéristique de la ligne. Il apparaît ainsi que le signal B obtenu en sortie de la ligne 22 voit son amplitude diminuée de moitié par rapport à celle du signal d'entrée.

Le circuit de retard $R_1$ est constitué de façon analogue par une ligne à retard analogique 25, par exemple de même type que la ligne 22, dont les extrémités sont connectées respectivement au signal d'entrée E par l'intermédiaire d'une résistance 24 et à la masse par l'intermédiaire d'une résistance 26, chacune d'elles étant égale à l'impédance caractéristique de la ligne . Le signal C, dont l'amplitude est de la même manière divisée par deux par rapport à l'amplitude du signal E, est prélevé sur la sortie de la ligne à retard 25.

**Revendications**

1. Dispositif de détection d'un train d'impulsions, comportant :

-des moyens de détection (D) de la valeur de crête ($V_c$) de la première impulsion du train ;

-des premiers moyens de retard analogiques ($R_0$), recevant le train d'impulsions et lui conférant un premier retard ($\tau_0$) ;

-un premier comparateur ($C_0$), assurant la comparaison du niveau du signal de sortie (B), dit premier signal, des premiers moyens de retard ($R_0$) à la demi-valeur de crête ($V_c/2$) de ce signal, et fournissant un signal (G) lorsque ce premier signal (B) devient égal à sa demi-valeur de crête et tant qu'il lui reste supérieur;

ledit dispositif de détection étant caractérisé par le fait qu'il comporte en outre :

-des deuxièmes moyens de retard analogiques ($R_1$), recevant le train d'impulsions et lui conférant un deuxième retard ($\tau_1$), différent du premier retard ($\tau_0$) ;

-un deuxième comparateur ($C_1$), assurant la comparaison du niveau du signal de sortie (C), dit deuxième signal, des deuxièmes moyens de retard ($R_1$) à la demi-valeur de crête ($V_c/2$) de ce signal et au premier signal (B), et fournissant un signal (J) lorsque le deuxième signal (C) devient égal soit à sa demi-valeur de crête, soit au premier signal (B), et ce tant que le deuxième signal (C) reste supérieur au plus grand des deux signaux auxquels il est comparé ;

-des moyens logiques (L) recevant les signaux de sortie des premier (6) et deuxième ($C_1$) comparateurs et fournissant un signal (S) lorsqu'il y a coïncidence des deux signaux d'entrée.

2. Dispositif selon la revendication 1, caractérisé par le fait que le deuxième retard ($\tau_1$) est inférieur au premier retard ($\tau_0$).

3. Dispositif selon la revendication 2, caractérisé par le fait qu'il comporte en outre des troisièmes moyens de retard ($R_2$) conférant un troisième retard prédéfini ($\tau_2$) au signal (J) issu du deuxième comparateur ($C_1$), à destination des moyens logiques (L), le troisième retard ($\tau_2$) étant inférieur à la différence entre les premier ($\tau_0$) et deuxième ($\tau_1$) retards, mais voisin de cette différence.

4. Dispositif selon l'une des revendications précédentes, caractérisé par le fait que les moyens logiques (L) comportent une porte ET.

5. Dispositif selon la revendication 3, caractérisé par le fait que les troisièmes moyens de retard ($R_2$) comportent un monostable.

6. Dispositif selon l'une des revendications précédentes, caractérisé par le fait que les moyens de détection (D) comportent :

-un amplificateur différentiel (11) recevant le train d'impulsions sur sa première entrée (+) ;

-une diode (12) connectée par son anode à la sortie de l'amplificateur (11) ;

-une capacité (13) connectée entre la cathode de la diode (12) et la masse ;

-un transistor (14) dont la base est connectée à la cathode de la diode (12), le collecteur à une alimentation électrique et l'émetteur à la deuxième entrée de l'amplificateur (11), la valeur de crête du train d'impulsions étant disponible sur l'émetteur du transistor (14).

7. Dispositif selon l'une des revendications précédentes, caractérisé par le fait que les premiers et/ou les deuxièmes moyens de retard comportent une ligne à retard du type LC (22 ; 25) aux extrémités de laquelle sont connectées respectivement deux résistances (21, 23 ; 24, 26) présentant chacune une impédance égale à l'impédance caractéristique de la ligne.

8. Dispositif selon l'une des revendications précédentes, caractérisé par le fait qu'il comporte en outre des moyens de découplage (6) recevant le train d'impulsions et le transmettant aux moyens de détection (D) et aux premiers et deuxièmes moyens de retard ($R_0$ et $R_1$).

9. Application du dispositif de détection selon l'une des revendications précédentes à un système de radionavigation de type DME, le train d'impulsions comportant deux impulsions.

# FIG_1

## FIG_2-a

## FIG_2-b

## FIG_2-c

FIG_3

FIG_4-a

FIG_4-b

FIG_4-c

FIG_4-d

FIG_4-e

FIG_5

0 194 924

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 058 095 (TH-CSF)<br><br>* Figures 1,6,7,9; page 2, ligne 9 - page 3, ligne 5; page 7, ligne 30 - page 13, ligne 28 *<br><br>--- | 1,4,6, 9 | H 03 K 5/153<br>G 01 S 13/78<br>G 01 S 13/14 |
| A | INSTRUMENTS AND EXPERIMENTAL TECHNIQUES, vol. 25, no. 4, partie 2, juillet-août 1982, pages 915-917, Plenum Publishing Corp., New York, US; A.A. ALEKSANDROV et al.: "Pulse shaper for time clamping to the rising edge of pulses in semiconductor detectors"<br>* Figures 1,2; page 916, lignes 1-20 *<br><br>--- | 1,4,6 | |
| A | ELECTRONICS, vol. 40, no. 9, 1 mai 1967, pages 69-70, New York, US; E.B. DALKIEWICZ et al.: "Intersecting waveforms trigger peak detector"<br>* Figures; pages 69,70 *<br><br>--- | 1,2,4 | DOMAINES TECHNIQUES RECHERCHES (Int. Cl.4)<br><br>H 03 K<br>G 01 S |
| A | IBM TECHNICAL DISCLOSURE BULLETIN, vol. 13, no. 8, janvier 1971, page 2361, New York, US; R. FRANKENY: "Peak detection"<br><br>--- | 1,2,4 | |
| A | US-A-3 668 532 (POTASH)<br><br>--- -/- | 1 | |

Le présent rapport de recherche a été établi pour toutes les revendications

| Lieu de la recherche<br>LA HAYE | Date d'achèvement de la recherche<br>11-06-1986 | Examinateur<br>FEUER F.S. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82

Office européen
des brevets

## · DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3 532 905  (ZIJTA et al.)<br><br>- - - - - | 1 | |

DOMAINES TECHNIQUES RECHERCHES (Int. Cl.4)

Le présent rapport de recherche a été établi pour toutes les revendications

| Lieu de la recherche<br>LA HAYE | Date d'achèvement de la recherche<br>11-06-1986 | Examinateur<br>FEUER F.S. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82